(19) Europäisches Patentamt / European Patent Office / Office européen des brevets

(11) **EP 3 192 080 B1**

(12) **EUROPEAN PATENT SPECIFICATION**

(45) Date of publication and mention of the grant of the patent:
**18.04.2018 Bulletin 2018/16**

(21) Application number: **16777585.7**

(22) Date of filing: **23.09.2016**

(51) Int Cl.:
**G21K 1/02** (2006.01)

(86) International application number:
**PCT/EP2016/072651**

(87) International publication number:
**WO 2017/055181 (06.04.2017 Gazette 2017/14)**

(54) **FOCUSSING OF GRATINGS FOR DIFFERENTIAL PHASE CONTRAST IMAGING BY MEANS OF ELECTRO-MECHANIC TRANSDUCER FOILS**

FOKUSSIERUNG VON GITTERN FÜR DIFFERENZIELLE PHASENKONTRASTBILDGEBUNG MITTELS ELEKTROMECHANISCHER WANDLERFOLIEN

FOCALISATION DE GRILLES POUR IMAGERIE À CONTRASTE DE PHASE DIFFÉRENTIEL AU MOYEN DE FEUILLES DE TRANSDUCTEUR ÉLECTRO-MÉCANIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.09.2015 EP 15187536**

(43) Date of publication of application:
**19.07.2017 Bulletin 2017/29**

(73) Proprietor: **Koninklijke Philips N.V.**
**5656 AE Eindhoven (NL)**

(72) Inventors:
• **MARTENS, Gerhard**
  **5656 AE Eindhoven (NL)**
• **VAN STEVENDAAL, Udo**
  **5656AE Eindhoven (NL)**

(74) Representative: **Versteeg, Dennis John**
**Philips Intellectual Property & Standards**
**High Tech Campus 5**
**5656 AE Eindhoven (NL)**

(56) References cited:
JP-A- 2008 048 910     US-A- 4 713 985
US-B1- 6 985 294

• **FRASSETTO FABIO ET AL: "Development of active gratings for the spectral selection of ultrafast pulses", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, vol. 8778, 3 May 2013 (2013-05-03), pages 87780C-87780C, XP060027135, DOI: 10.1117/12.2019980 ISBN: 978-1-62841-730-2**
• **YOSHIAKI AKIMOTO: "A transportable methane stabilized He-Ne laser", IEEE TRANSACTIONS ON INSTRUMENTATION AND MEASUREMENT, IEEE SERVICE CENTER, PISCATAWAY, NJ, US, vol. IM-36, no. 2, 1 June 1987 (1987-06-01), pages 633-635, XP011464654, ISSN: 0018-9456, DOI: 10.1109/TIM.1987.6312757**
• **LILLIE CHARLES ET AL: "Test results for an AOA-Xinetics grazing incidence x-ray deformable mirror", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, vol. 9208, 16 September 2014 (2014-09-16), pages 92080C-92080C, XP060039484, DOI: 10.1117/12.2064770 ISBN: 978-1-62841-730-2**

**Description**

FIELD OF THE INVENTION

The invention relates to a grating assembly, to an X-ray imaging apparatus, and to a method of manufacture of a grating structure.

BACKGROUND OF THE INVENTION

There was increasing demand for phase-contrast imaging during the last 5-10 years due to a breakthrough in the development on a novel differential phase-contrast imaging (DPCI) technique. This technique uses two or three X-ray gratings and Lau-Talbot interferometry. This development has triggered increased interest by manufacturers of diagnostic imaging equipment as well, because the technique is applicable to conventional X-ray imaging systems. A possible area of application of this technology is mammography.

A shortcoming of DPCI systems is the fact that the performance of the DPCI signals at towards the edges of the field of view degrade in a focus-centered imaging systems. This is because for grating trenches positioned towards the edge of the field of view, the ideal passage of the X-rays through the gratings is perturbed due to non-normal incidence upon the gratings. As a consequence of this, radiation shadowing effects show up which may cause a significant decrease of photon flux and interferometric fringe visibility.

US6985294B1; JP2008 048910 A ;and Frasetto Fabio et.al., in 'Devlopment of active gratings for the spectral selection of ultrafast pulses', Optomechatronic micro/nano devices and components II, Proceedings SPIE, p. 87780c, 2013, disclose gratings that are securely affixed to electrostrictive material.

SUMMARY OF THE INVENTION

There may therefore be a need to reduce shadowing effects in interferometric imaging systems.

The object of the present invention is solved by the subject matter of the independent claims where further embodiments are incorporated in the dependent claims. It should be noted that the following described aspect of the invention equally applies to the X-ray imaging apparatus.

According to a first aspect of the invention there is provided a grating assembly according to claim 1. The grating structure has ridges (formed in the first face of the grating) and the deformation causes said ridges to at least partly align with or towards a focus region or focus point located outside said grating assembly. The (at least partial) alignment can be brought about by bending at least a part of the said ridges or by tilting the ridges. The alignment is effected by mechanical forces acting on the ridge due to their coupling with the deforming layer. The grating structure is suitable in particular for (differential) phase contrast imaging and/or dark-field imaging and allows modifying the X-ray radiation when said radiation interacts with the ridges of the grating structure to so create diffraction effect based interference pattern.

More particularly, according to one embodiment, said ridges have respective tip portions that together form said first face of the grating structure and the layer of electrostrictive material is coupled to said tip portions of said ridges. This arrangement allows a more targeted application of the deformation action of the layer to the grating. In other words, this allows bending or tilting only the ridges (or parts thereof) whereas the remainder of the grating structure remains substantially undisturbed. This allows reducing the amount of force necessary to achieve the focusing of the grating assembly.

The proposed grating assembly is a radical departure from (purely mechanical) approaches to combat radiation shading effects where the whole of the gratings are being bent over, for instance, by forcing them to fit to a cylindrical shape by being bent around a curved support. Here we propose a quite different approach, ie, a slight slanting/tilting or bending of the grating ridges by electrostriction of the electrostrictive layer, which is coupled to terminal portions of the grating ridges. Previously, it was not uncommon for the gratings to break during bending. In contrast, the approach proposed herein allows more precise focusing in finer graduations and the gratings are less likely to break during focusing with the use of electrostrictive behavior. As mentioned, the focusing allows reducing radiation shadowing which in turn results in a clearer definition (that is, visibility) of the interference pattern at a detector of an imaging apparatus. This is turn results in more accurate phase contrast or dark field imagery because it is information from this interference pattern which is signal-processed into this imagery.

According to one embodiment, the grating comprises a stiffening element (such as a plate or disk or other) coupled to a second face of said grating structure distal from said layer of electrostrictive material.

According to one embodiment, a or a further stiffening element is coupled to the layer of electrostrictive material so as to sandwich the layer of electrostrictive material between said plate or disk and said grating structure. Either one of the stiffening elements allows for a more efficient or targeted transfer of the mechanical forces (that are caused by the deformation of the layer) to the ridges.

According to one embodiment, the grating assembly comprises a pair of electrodes configured to apply said voltage across the layer of electrostrictive material. These electrodes may be arranged as separate, dedicated components or it is the grating structure and one of the stiffening element themselves that are used as electrodes.

According to one embodiment, the grating assembly comprises a plurality of electrode pairs configured to apply mutually different voltages at mutually different locations across the layer. Alternatively or in addition to this, and according to one embodiment, the layer has a non-uniform thickness profile across its lateral dimensions. The plurality of different voltages than can be applied by the plurality of electrode pairs or the non-uniform thickness profile (measured relative to a lateral dimension of the layer) can be used to achieve a linear displacement profile of the ridges.

According to the invention, the first face of the grating structure and an opposing face of the layer are structured so as to interlock with each other. In addition thereto, the second face of the grating structure and an opposing face of the plate or disk may be structured so as to interlock with each other. One or both of the interlockings allow for better grip between the respective faces coupled to each other and thus for a more efficient application of the layer's deformation achieve the alignment of the ridges towards the focal region or focal point.

According to one embodiment, the grating structure is arranged in an articulated manner with respect to at least one of the ridges. In other words, the grating structure includes at least one functional element that acts like joint. This promotes a more favorable material behavior of the ridges for focusing purposes, when the ridges are subjected to the mechanical forces caused by the deformation of the electrostrictive layer. More particularly, a tilting behavior of the ridges can be achieved this way rather than a bending behavior. Tilting allows for better alignment and for a clearer spatial definition of the focal point.

More specifically, and according to one embodiment, the grating ridges have respective base portions arranged distal from said tip portions and from said electrostrictive layer and in one embodiment said base portions are tapered to implement said articulated structure. In yet another embodiment, the articulated structure is provided by the ridges forming discrete parts of said grating structure, and the ridges being coupled, via respective packings of filler material, at their respective base portions with a base substrate of the grating structure.

In one embodiment, a flexibility of said packings of filler material is higher than that of the ridges or of the base substrate. According to one embodiment, a plurality of furrows is formed in the base substrate for at least partly receiving the respective packing of filler material. This interposing of a flexible filler material promotes better tilting behavior of the ridges.

According to one embodiment, the ridges are formed in straight lines in the grating structure or wherein the ridges are arranged in concentric circles or in concentric polygons.

According to a further aspect of the present invention, there is provided an X-ray imaging apparatus, comprising:

- an X-ray source to emit X-radiation from a focal spot; and
- a grating assembly as mentioned above.

According to one embodiment, the X-ray imaging apparatus comprises a voltage source for applying a voltage to said grating assembly so as to align ridges of said grating assembly to a focal region, wherein a position of said focal region varies with said voltage along an axis parallel to an optical axis of said X-ray imaging apparatus.

According to one embodiment, the X-ray imaging apparatus comprises a translator stage configured to apply a lateral force to the grating assembly across an optical axis of the X-ray imaging apparatus thereby causing a lateral shift of said focal region along an axis perpendicular to the optical axis of the X-ray imaging apparatus.

According to one embodiment, the X-ray imaging apparatus is configured for varying said voltage and/or said lateral force such that the focal region or focal point is positionable to include or to coincide with said focal spot. In other words, the focal region or focal point of the grating assemblies can be adjusted spatially along at least one or two spatial directions: along an optical axis of the imaging system and (if the translator stage is used) in a direction across said axis. This affords a greater degree of freedom when adjusting for the focal spot of the imaging system at hand.

According to a yet further aspect of the present invention, there is provided a method of manufacture of a grating assembly according to claim 12. According to one embodiment, the method comprises the step of, prior to the mounting, filling trenches, formed between said ridges, with a stabilizer.

According to one embodiment, the method comprises eliminating said base substrate.

According to one embodiment, the method comprises mounting a plate onto the base portions.

According to one embodiment, the method comprises eliminating said stabilizer.

The X-ray imaging apparatus including one or more of the proposed grating assemblies allows for useful application in a clinical environment such as a hospital. More specifically, the present invention is very suitable for application in any DCPI imaging modality, such as mammography imaging systems, planar or multi-planar radiography systems or even CT (computed tomography) or others. The present invention can be used in diagnostic radiology and interventional radiology for the medical examination of patients. In addition, the present invention allows for useful application in an industrial environment. More specifically, the present invention is very suitable for application in non-destructive testing (e.g. analysis as to composition, structure and/or qualities of biological as well non-biological samples) as well as security scanning (e.g. scanning of luggage on airports).

## BRIEF DESCRIPTION OF THE DRAWINGS

Exemplary embodiments of the invention as well examples not claimed as the present invention will now be described with reference to the following drawings wherein:

Figure 1 shows a schematic frontal elevation view of an interferometric imager;
Figure 2 shows a first state of a grating assembly for use in an interferometric imager as per Figure 1;
Figure 3 shows a second state of the grating assembly of Figure 2;
Figure 4 shows views of an electrostrictive layer as used in the grating assembly of Figures 2 and 3;
Figure 5 shows two views of different states of a grating assembly;
Figure 6 shows a surface structure in a grating assembly according to a first embodiment;
Figure 7 shows plan views of circular grating structures;
Figure 8 shows a second interferometric imaging apparatus;
Figure 9 shows bending of ridges of an interferometric grating structure;
Figure 10 shows in more detail a bending profile of a ridge of a grating structure;
Figure 11 shows different articulated grating structures;
Figure 12 shows further articulated grating structures according to embodiments of the claimed invention; and
Figure 13 shows a flow chart of a method of manufacturing an articulated grating structure.

## DETAILED DESCRIPTION OF EXAMPLES AND EMBODIMENTS

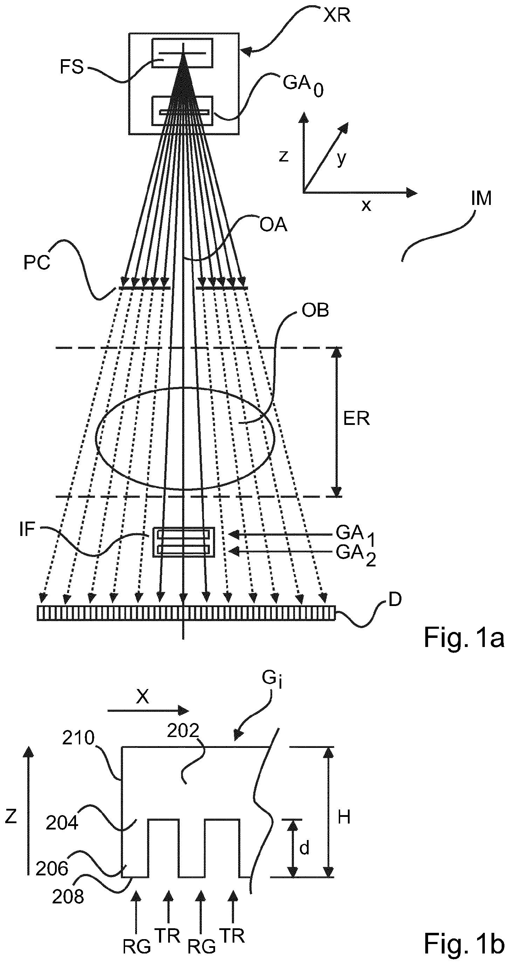

Panel a) of Figure 1 affords a schematic side elevation view of an X-ray imaging apparatus IM. The X-ray imaging apparatus comprises an X-ray source XR and a radiation sensitive detector D arranged across an examination region ER opposite said source XR. Preferably, but not necessarily, the X-ray detector D is 2D (two-dimensional). In other words, the X-ray detector is a "true" 2D structure where a plurality of detector pixels are arranged in rows and columns as an array to form a 2D X-ray radiation sensitive surface. The detector pixels are capable of registering X-ray radiation emitted by the X-ray source and to convert the registered radiation into electrical signals from which images can be derived. Non-limiting exemplary embodiments include flat panel detectors or (analog or digital) image intensifier systems. Alternatively, the X-ray detector D may also be arranged as a "line detector". Line detectors comprise a single or a plurality of discretely spaced individual lines of detector pixels. Line detectors with a plurality of detector pixel-lines are sometimes used in mammography systems whereas single line detectors are occasionally used in CT (computed tomography) systems with DPCI capability.

The examination region ER is suitably spaced to at least partly receive therein an object OB whose internal constitution or configuration one wishes to image for. The object to be imaged may be inanimate or animate. For instance the object may be a piece of luggage or other sample to be imaged such as in non-destructive material testing etc. Preferably however a medical context is envisaged where the (animate) "object" is a human or animal patient or is at least an anatomic part thereof as it is not always the case that the whole of the object is to be imaged but only a certain anatomic region of interest.

The X-ray imaging apparatus IM further comprises an interferometer IF arranged between the X-ray source and the detector D. In the following it will be convenient to introduce a reference frame of axis X, Y, and Z to better explain operation of the X-ray imaging apparatus as proposed herein. Axis X, Y define the image plane or plane of the field of view of the detector D. For instance, axis X, Y may be taken to extend, respectively, along two adjoining edges of the detector D. Perpendicular to the image plane X, Y is axis Z. This axis corresponds in general to the propagation direction of the X-ray beam which emanates from a focal spot FS of the X-ray source XR. Also, axis Z is parallel to the optical axis OA of the X-ray imaging apparatus. The optical axis runs form the focal spot FS of the source XR to the center of the image plane of the detector D. The optical axis may be movable, in particular rotatable or translatable, relative to the imaging region. Examples are CT scanners or tomosynthesis imagers as used in mammography scanners, or C-arm X-ray imagers.

Referring now back in more detail to part a) of Figure 1, the X-ray imager IM has a multi-channel imaging capability which is at least partly afforded by the interferometer IF built into the X-ray imaging apparatus. "Multi-channel imaging", as used herein, means in particular the capability of imaging for i) a spatial distribution of refraction activity caused by the object (this is phase contrast imaging) and/or ii) for spatial distribution of small angle scattering (dark field imaging) activity as caused by the imaged object OB. In addition thereto, the more traditional way of imaging for spatial distribution of absorption in the object OB may also be possible. This type of multi-imaging capability is sometimes referred to as DPCI (differential phase contrast imaging), but this naming convention is not to be construed so as to exclude imaging for the other image signals, dark-field and/or absorption, respectively.

In one embodiment, the interferometer IF comprises two grating assemblies GA1 and GA2 although single grating interferometers (having only a single grating assembly) are not excluded herein and will be described later below. In one embodiment, the interferometric grating assemblies GA1 and GA2 are arranged in between the X-ray source XR and X-ray detector D so that the examination region ER is defined between the X-ray source and the interferometer IF. More specifically, it is the space between the focal spot FS and the X-ray detector's radiation sensitive surface where the two grating assemblies GA1 and GA2 are arranged with the examination region then being formed by the space between the focal spot and the grating assembly GA1or (if any) between a source grating assembly GA0 (on which more later below) and the grating assembly GA1 of the interferometer. As a variant, an interferometer geometry inverse to the one shown in Figure 1 may be used instead. In this inverse geometry, the examination region ER is sandwiched between the interferometer IF, that is, the examination region ER is sandwiched between grating assemblies GA1 and GA2 or, in the single grating interferometer embodiment, the examination region is between the grating assembly GA1 and the detector. The imager is in one embodiment of the scanning type. In one embodiment, such as in tomosynthesis, the interferometer IF is arranged in a movable scan arm and the interferometer is scanned under the object in a horizontal or curved scan motion. In one embodiment the interferometer IF is scanned relative to the (in this embodiment) stationary detector D whereas in another embodiment, both detector D and interferometer IF, are moved together in the scanning motion. The size of the gratings assembly GA1, GA2 in the interferometer IF is such that it essentially covers the whole of the radiation sensitive surface of the detector D or the size of the gratings assemblies in the interferometer is smaller than the radiation sensitive surface of the detector D. Optionally there is pre-collimator PC between the source XR and the object OB. In addition or instead there may also be a post-collimator between object and detector.

It will be convenient in the following to refer to the grating assembly GA1 as the phase grating assembly and to grating assembly GA2 as the analyzer grating assembly.

As briefly mentioned above, in some embodiments, there is, in addition to the at least one interferometric gratings GA1, GA2 of the interferometer IF, a further grating assembly GA0, called the source grating assembly. The source grating assembly GA0 is arranged in proximity at a distance f0 from the focal spot FS of the X-ray source. For instance, the source grating G0 may be arranged at an X-ray window of a housing of the X-ray tube unit XR. If there is a source grating, the examination region is between the source grating assembly GA0 and the interferometer IF, in particular between source grating assembly GA0 and grating assembly GA1. The function of the source grating G0 is to make the emitted radiation at least partly coherent, as the interferometer IF requires this coherence for its operation. The source grating assembly GA0 can be dispensed with, if an X-ray source is used which is capable of producing native coherent radiation.

Each of the one or two interferometric gratings assemblies GA1,GA2 and the source grating assembly GA0 include respective gratings structures, or "gratings" for short, referred to herein as the source grating G0, the phase grating G1 and (if any) the analyzer grating G2, respectively. Generically, the respective gratings are referred to herein as "G$i$" and, GA$i$ being a generic reference to the respective grating assembly, with $i$ = 0, 1, 2.

In one embodiment, the gratings $G_i$ are manufactured by photo lithographically processing suitable substrates such as a silicon wafer (rectangular or even square shaped but other shapes such as circular may also be called for in other contexts). Inset b) in Figure 1 shows a close-up of a grating profile along the X axis, with reference numeral 210 designating one edge of the grating structure. The plane of the gratings $G_i$ is essentially parallel to the X-Y plane. A pattern of periodic rulings is formed in a surface of a silicon substrate as a sequence of parallel trenches, with any two neighboring trenches separated by respective bars or ridges RD. In inset b) of Figure 1, the rulings (that is, the pattern of trenches and ridges RD) run along the Y-direction, that is, extend into the drawing plane in Figure 1. The X axis runs perpendicularly across the ridges RG/trenches TR and the Z-axis is perpendicular to the plane of the gratings Gi. In the case of the analyzer grating G2, the trenches TR are filled with a suitable filling material such as gold or other high-Z number material to cause the desired attenuation behavior. The trenches TR are formed into the substrate at a certain depth d which runs parallel to the Z-axis. The depth does not run the total height H of the substrate to preserve the integrity of the grating Gi so that a base body 202 is formed by the remainder of the substrate. Once the rulings are applied onto one surface of the substrate (which in Fig 1b is the lower surface), the grating Gi so obtained can be structurally understood to comprise said base body 202 from which the ridges RG project away, with any ridge RD having on either one of its sides a respective trench TR. Each ridge RG has a base portion 202 at which the respective ridge transitions into the base body 202. Distal from said base portion 202, there is a respective tip portion 206 of each ridge which terminates into respective terminal portions 208 for each ridge RG. The respective terminal portions 208 then together form the ruled face (also referred to herein as the "first" face) of the grating Gi, as opposed to the other, distal face, which is non-ruled. The function of the rulings is to partially absorb the x-rays in the case of the absorbing gratings G0 and G2 and to create a diffraction based Talbot interference pattern in the case of the phase shifting G1 grating. This will be explained in more detail below. Functionally, and consistent with the naming of the various grating assemblies GAi, the grating G1 is either an absorber grating or preferably a phase shift grating, whereas G2 is an absorber grating.

The radiation coherence conferring source grating G0 is in general an absorber grating. However other functional combinations are not excluded herein. Although grating structures of silicon are mainly envisaged herein, other material are not excluded, such as some types of plastics.

The ruling patterns are preferably one dimensional but may also be two dimensional such as to confer a checker board pattern in which there are two sets of trenches or ridges: one set runs in the Y-direction, whilst the other runs across the first in the X-direction. In the 1D example the rulings extend only in one direction across the surface of the substrate.

During a DPCI, or more generally, interferometric, imaging operation, the at least partly coherent radiation emerges downstream the source grating G0 (if any), passes then through the examination region ER and interacts with the object OB therein. The object then modulates attenuation, refraction, and small angle scattering information onto the radiation which can then be extracted by operation of the interferometer IF gratings G1 and G2. More particularly the grating G1 diffracts the coherent radiation into a phase shifted interference pattern and this is then replicated where the analyzer grating G2 is located. The analyzer grating essentially translates the phase shift information encoded in the diffracted inference pattern into an intensity pattern which is then detectable at the X-ray detector D as fringes of a Moire pattern. Yet more particularly, if there was no object in the examination region there is still an interference pattern detectable at the X-ray detector D, called the reference pattern which is normally captured during a calibration imaging procedure. The Moire pattern comes about by especially adjusting or "de-tuning" the mutual spatial relationship between the two gratings G1 and G2 by inducing a slight flexure for instance so that the two gratings are not perfectly parallel. Now, if the object is resident in the examination region and interacts with the radiation as mentioned, the Moire pattern, which is now more appropriately called the object pattern, can be understood as a disturbed version of the reference pattern. This deviation from the reference pattern can then be used to compute a desired one, or two or all of the three images (attenuation, phase contrast, dark field). For good imaging results, the detuning of the gratings G1, G2 is such that a period of the Moire pattern should extend for a few of its cycles (two or three) across the field of view of the detector. The Moire pattern can be Fourier-processed for instance to extract the at least one (in particular all) of the three images. Other types of signal processing such as phase-stepping techniques are also envisaged herein and have been reported elsewhere such as the phase stepping technique by F Pfeiffer et al in "Phase retrieval and differential phase-contrast imaging with low-brilliance X-ray sources", Nature Physics 2, 258 - 261 (2006) or the Fourier method of A Momose et al in "High-speed X-ray phase imaging and X-ray phase tomography with Talbot interferometer and white synchrotron radiation", in OPTICS EXPRESS, 20 July 2009 / Vol. 17, No. 15. As a side observation and for the sake of completeness, the single grating embodiment of the interferometer IF can be implemented by integrating the analyzer grating G2 functionality into the X-ray detector D itself. This can be achieved in one embodiment (but not necessarily in all embodiments) by careful arrangement of the pixel geometry, in particular the inter-spacing between the pixels to replicate the G2 functionality. In this embodiment, the X-ray detector D preferably has a pixel pitch sufficiently small, hence a spatial resolution sufficiently large, for detecting, i.e, adequately resolving, the interference pattern generated by the grating G1 for the purpose of differential phase contrast imaging and/or dark field imaging. For that purpose the X-ray detector may be a high resolution X-ray detector, with spatial resolution in the micrometer range or sub-micrometer range, such as about 1 micrometer or even higher.

The interferometer IF as described above is what is commonly referred to as a Talbot-Lau interferometer. Much of the accuracy of the imaging capability of the interferometric X-ray apparatus rests with the distinctness with which the Moire pattern or interference pattern is detected at the detector D. Said distinctness can be quantified by the interferometric concept of "visibility". Visibility is an experimentally verifiable quantity defined for instance as the ratio $(I_{max}-I_{min})/(I_{max}+I_{min})$. Said differently, the visibility can be understood as the "modulation depth" of the interference pattern, that is, the ratio of fringe amplitude and the average of fringe oscillation. The visibility of the interference pattern is in turn at least partly a function of "design energy" at which the x-radiation (as produced by the X-ray source) illuminates the interferometer and the source grating G0 (if any).

Another factor that affects the visibility is the geometry of the gratings, in particular their aspect ratios and the pitches p0, p1, p2 of the source grating G0, phase grating G1 and G2, respectively. "Pitch" as used in the present interferometric context describes the spatial period of the grating rulings. The aspect ratio describes the ratio between the depth d of the respective trenches TR formed in the grating's substrate and the distance between two neighboring trenches.

The geometry of the grating together with the radiation wavelength at the design energy determine the distance *l* (not shown) between source grating G0 and phase grating G1 and the so called Talbot distance, that is, the intra-grating distance d (not shown) between grating G1 and grating G2 through the interferometer. The accuracy of the interferometric imaging rests on the precision of the gratings geometry and the accuracy of the observance of the Talbot distances, as it is only there where the early mentioned replication of the interference patterns occurs at the required visibility. For instance, as the source grating G0 acts as an absorber grating, this imposes certain requirements on the trench height required in order to perform this function properly. Similar demands are required for the analyzer grating G2 (also configured in general as an absorber grating) which operates essentially, as explained above, to scale up the interference pattern as produced by the G1 source in order to make the interference pattern detectable at the detector for a given resolution. Also, grating G1 is adapted to produce the interference pattern down-stream at the desired Talbot distance (where the absorber grating G2 is positioned) with a precisely defined phase shift (usually $\pi$ or $\pi/2$). Again, to ensure that the interference pattern is precisely replicated at the desired Talbot distance at the required phase shift, a suitable aspect ratio is required for the specific design energy that is desired for a given imaging task.

However even if the imaging system IM is operated at the envisaged design energy with correct grating geometries and the interferometer IF set up to the correct Talbot distances, there is still a loss of visibility observed which is caused by radiation shadowing. In other words, parts of the incident radiation are not used to produce the interference pattern. This effect is particularly prominent if the direction of radiation is not parallel to the direction of thickness or depth D of the trenches but is oblique thereto. In other words, this effect is inevitable if the radiation beam geometry is a fan beam rather than a parallel beam. The further away the trenches are from the optical axis, the more prominent the radiation shadowing effect is.

As a remedy to combat radiation shadowing effects, the grating assemblies GAi include, in addition to the respective grating structure Gi, an electro-magnetic transducer sheet or foil applied to the ruled surfaces of the respective grating GI. The electromechanical transducer foil is formed from a layer of electrostrictive material EL. This layer is coupled with sufficient grip and rigidity to the ruled surface of the grating structure, that is, to the tips or terminal portions 208 of the ridges. The electrostrictive layer has the property that upon application of a voltage through a pair of (preferably compliant) electrodes EC, an electrostatic pressure occurs. This results in mechanical compression of the electrostrictive layer: the layer contracts in direction Z, that is, in the direction of the thickness of the layer or, said differently, in the direction of the height d of the ridges. Because of an assumed incompressibility of the layer material, the layer will naturally attempt to expand in the two spatial directions X, Y of the layer's plane. The strain component in X direction, across the direction in which the ridges run, will exert a lateral force along the X axis and across the ridges. If adjusted properly, a part of the grating structure Gi, in particular the ridges, can then be bent over by said lateral force to at least partly align with or towards a focal point outside the grating assembly that coincide with the focal spot FS of the imager IM if the voltage is chosen appropriately. The trenches between the so aligned ridges are then likewise aligned with the focal spot and a higher proportion of the radiation energy can then be used for diffraction into the interference pattern thus increasing efficiency.

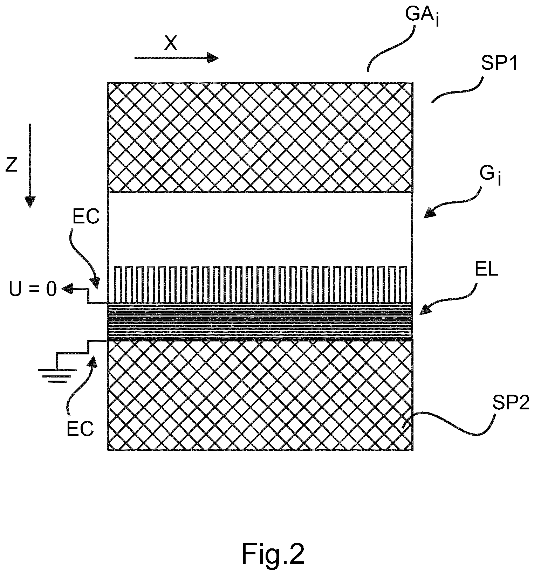

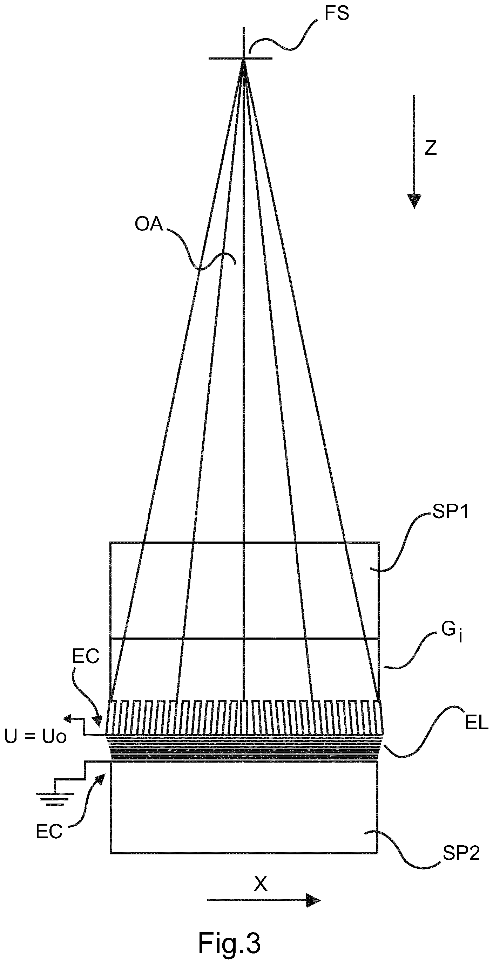

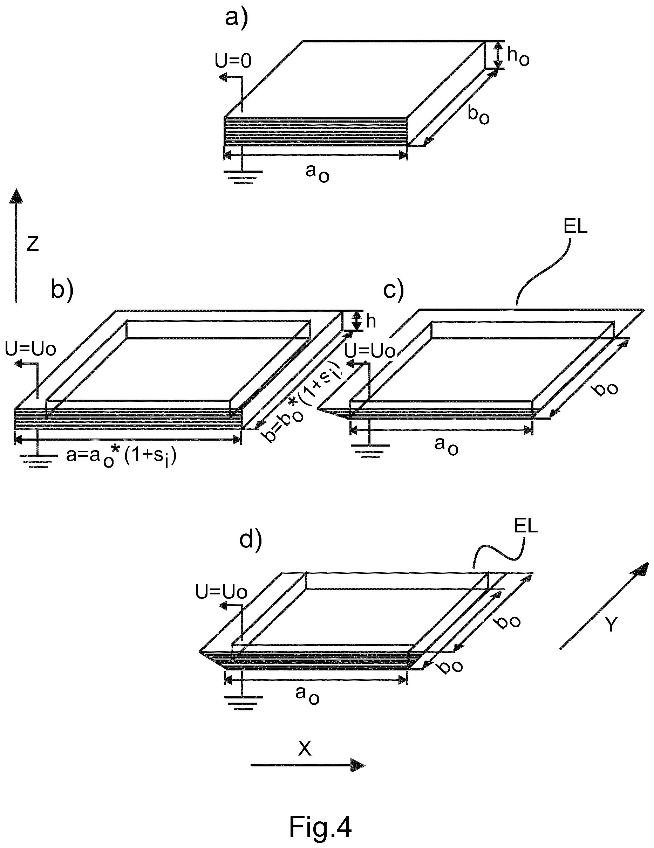

In more detail, Figure 2 shows a cross section in the Z-X plane across the grating assembly GAi. Specifically, Figure 2 shows the grating assembly in a relaxed state or non-electrified state, that is, when no voltage is applied through electrodes EC. All ridges RD are now aligned parallel to optical axis. In this situation radiation shadowing is likely to occur for a fan beam. In contrast, the cross-section view across the same plane as per Figure 3 shows the grating assembly GAi in an electrified or deformed state where the electrostrictive layer is deformed by application of the actuation voltage U0 into lateral expansion. The mechanical coupling of the layer EL to the tips 208 of the ridges thus causes the ridges RD, the trenches TR, to align towards a common location, such as the focal spot FS of the imager. In other words, the grating assembly GAi, and more particularly its grating structure Gi, can be focused on the focal spot of the imager. The lateral force exerted by the lateral expansion of the electrostrictive layer acts on the grating structure in both directions (negative and positive) along the X axis. In consequence, some of the ridges, those situated towards one edge of the grating, are being bent over to the right and those situated towards the other edge of the grating to the left, whilst ridges situated in a central region of the grating $G_i$ are largely left undisturbed. Put differently, the further away the ridge is from the center of the grating structure, the more pronounced the bending or the tilting is. Preferably then, the assembly GAi is so mounted in the imager IM that the optical axis OA runs through said central part of the grating Gi. Ideally, the ridges are rather tilted or slanted as opposed to being bent and the earlier behavior can be promoted by using a material of sufficient flexibility for the grating structure. As shown in the Figure3, because the electrostrictive layer EL acts to stretch the ridges in opposite directions (along X and -X that is), the focal point is defined "behind" the grating Gi(when viewed along Z direction), that is, the focal point is situated in the space between the X-ray source and the grating G*i*. Yet in other words, the grating assembly GAi, when is use, is so mounted in the imager that the ridges project away from the base body of the grating structure and away from the X-ray source XR and towards the detector of the image. Reference is now made to Figure 4 where properties of the electrostrictive process are examined in more detail and how the expansion behavior can be usefully manipulated for present purposes. A layer EL or foil of primary height or thickness $h_0$ made of an elastomer having a dielectric constant $\varepsilon$ is provided with compliant (i.e. flexible) electrodes at its upper and lower surfaces as per Fig. 4a. For consistency with the previously introduced frame of reference X-Y-Z, the edges *a,b* are assumed to run parallel to the axis X and Y respectively, with the height *h* or layer thickness extending along the Z axis. When applying a voltage of magnitude *U* onto these electrodes, electric charges show up at the electrodes, which due to electrostatic forces will set up a force between these electrodes perpendicular to the surface of the layer. The force per area of the electrode surface is the pressure, which the layer EL has to withstand.

The pressure p is given by

$$p = \varepsilon_o * \varepsilon * E^2 \text{ with } E \text{ (electric field) given by } E = U/h$$

and

$\varepsilon_o$ dielectric permittivity in vacuum;
$\varepsilon$ = material dependent relative dielectric constant; and
$h$=residual thickness of the foil, that is, the thickness during application of the voltage (in contrast, $h$, as introduced above, designates the thickness in the relaxed state when no voltage is applied).

The pressure induces a mechanical stress $\sigma_h$ in the foil and a strain response $s_h$ will happen. The stress-strain relation is described via the Young modulus Y by

$$\sigma_h = Y * s_h \text{ (the stress - strain relation).}$$

A brief remark on notation: in order to avoid confusion with the electric field E, here we use the term "Young modulus Y" and not the coefficient of elasticity E in the stress - strain relation.

Summarizing basic facts:

a) the stress in the plate is set up by the pressure caused by the electric field,
b) the magnitude of the stress $\sigma_h$ in vertical direction is equal to the magnitude of applied electro static pressure: ($\sigma_h$ = p) and
c) the strain $s_h$ in vertical direction is given by the stress-strain relation.

Thus we have $s_h$ = -p/Y = - $\varepsilon_0 * \varepsilon / Y * E^2$ = - $Q*E^2$, wherein the signum "-" indicates that the thickness h of the plate shrinks when the electric field / voltage is applied. The quantity Q = $\varepsilon_0 * \varepsilon / Y$ is known as the electrostrictive coefficient of the material. From here we can see that a material with high dielectric constant $\varepsilon$ and a high elasticity 1/Y (low Young modulus) would be the optimal one with respect to electrostriction.

We turn now to the question of how the vertical strain $s_h$ translates into a lateral strain $s_1$ in-plane with the layer surface. To answer this, we make use of the fact that most of the elastomers are not compressible. This means that the volume V of the plate remains constant. Therefore we have for the primary volume V = $h_o * a_o * b_o$ = const. For the electrostrictive case we get: V = $h_o*(1+s_h) * a_o*(1+s_a) * b_o*(1+s_b)$ = $h_o * a_o * b_o$, with $s_h$, $s_a$, $s_b$ as the strains in the appropriate directions along axis Z, X and Y, respectively.

For a uniform material having an isotropic behavior a common lateral strain $s_l$ is introduced for $s_a$ and $s_b$ as per $s_l = s_a = s_b$. Because the volume remains constant we arrive at: $(1+s_h) * (1+s_l)^2 = 1$. Solving this equation for $s_l$ we get: $s_l$ = 1/(sqrt(1+s_h)-1 ~ -0,5$s_h$ for small strains $s_h$. For the case of compliant electrodes, which due to their definition do not constrain any lateral expansion of the plate, the plate will be automatically stretched in a and b direction with half of the vertical strain $s_h$ (compared to its height reduction), when a voltage is applied. This case is sketched in Fig. 4b. In the next step, (see Fig 4c) we introduce a first constraint. The lower electrode now is assumed to be non-compliant (i.e. stiff) in both directions: *a* and *b*. This can be achieved by gluing the electrode onto a rigid plate of sufficient stiffness. Now, no expansion of the lower surface of the elastomer plate is allowed; a = $a_o$ and b = $b_o$ for the lower surface. The electrode of the upper surface remains still compliant. Under this restriction the previously rectangular shape of the plate converts to a flat, truncated pyramid which is arranged upside down in Fig. 4c. In the last step we introduce a second constraint: the upper surface is only allowed to expand in the *a*-direction. The expansion in *b*-direction is blocked by whatever means. The result is displayed in Fig. 4d. The directions of the vertical walls a-h (along Z) of the layer EL which primarily were in-plane with the drawing plane remain plane parallel to the X-Y plane. However, the layer EL's walls b-h perpendicular to the drawing plane, that is those parallel to the Z-Y plane, will be symmetrically slanted in opposite directions. As a consequence, the cross-section of the layer EL in the Z-X plane ("front and back side") of the layer EL will assume a trapezoidal shape.

From the application of the constant volume condition the strain relation yields:

$$s_{ua} = - 2*s_h$$

The magnitude of the strain $s_{ua}$ of the upper surface of the plate in a-direction is twice the magnitude of strain $s_h$ caused by the electric field / voltage in the height direction. Thus one arrives at the following relation for this special case of constraining (non-compliant) electrodes, where expected strain $s_{ua}$ of the upper surface in X/a-direction is:

$$s_{ua} = -\gamma \, 2 * s_h = -\gamma *2* \varepsilon_o * \varepsilon / Y * E^2 = -\gamma *2 *Q*E^2 = -\gamma \, 2*Q*(U_o/h_o)^2 \qquad (1)$$

with $\gamma$ as a correction factor about unity, accounting for deviations from the ideal geometry as assumed in Fig. 4d.

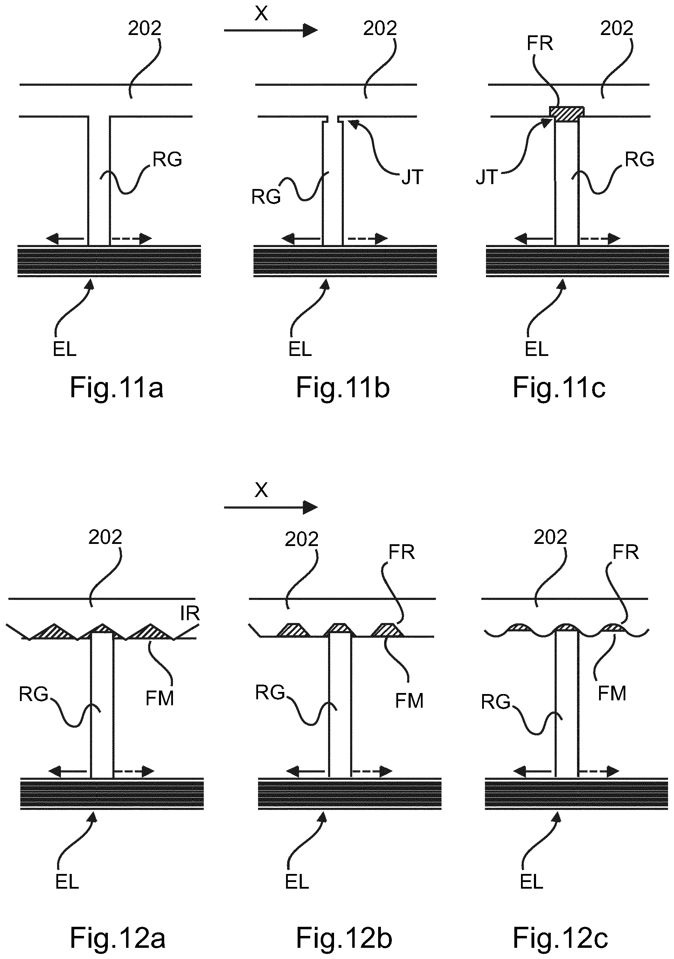

The partial deforming behaviors of layer EL as explained above in relation to Figures 4c) and d) are the preferred ones. These behaviors can be realized by arranging a suitable restriction mechanism to restrict the deformation action or strain in the layer EL to use the deformation more efficiently. In other words, the deformation restriction mechanism restricts deformation of the layer where it is not wanted and helps concentrate the deformation action to where it is wanted. Ideally, it is the portion of the layer EL which is coupled to the ruled surface of the grating that is supposed to deform though lateral expansion. More specifically, the deformation restriction mechanism allows restricting the deformation action into a lateral at said portion. The deformation restriction mechanism can be achieved by a stiffener element such as a plate SP2 as shown in the Figures 2 and 3. The stiffener plates are coupled by fusion or gluing with sufficient grip and rigidity to surfaces of the electrostrictive layer distal to the grating structure. Said differently, the stiffening plate SP2 is affixed to the other surface of the electrostrictive layer distal to the surface that is glued to the ruled face of the grating structure GI. The portion of the electrostrictive layer that is coupled to the grating Gi will thus experience more deformation than the more distal portions and the deformation action is concentrated at the grating interface into a lateral one thus implementing the configurations as per Figs 4d. In other words, when applying a system of compliant electrodes EC onto the surfaces of the layer EL, we will have situations comparable to Fig. 4. If the coupling, e.g. via adhesion, between layer EL to the grating tip portions 206 and the coupling between the distal surface of the layer and the opposing surface (which in Figures 2, 3 the upper) of the (lower) flattening plate SP2 is sufficiently large, we have partly constrained conditions of freedom for the lateral expansion of the layer EL as per Fig. 4d. When now a voltage is applied through a system of compliant electrodes CE, the rectangular cross-section (in the X-Z or Y-Z plane) of the layer will transform from an initial one (eg, rectangular cross section) into a trapezoidal cross section because the only freedom for lateral expansion of the layer is given at the tips 206 of the grating ridges 206 in a direction perpendicular to the direction (X) in which the ridges RD of the grating Gi run. Thus the tips 206 of the gratings ridges RG will be gradually shifted in (horizontal) direction X by the expansion of the upper surface of the electrostrictive layer as shown in Figure 3. Due to the symmetric expansion of the surface of the layer that is coupled to the grating Gi, the ridges RG now seem to be "virtually" focused to a focal point outside the grating assembly, which, ideally, coincides with the focal spot FS. The effect of the deformation restriction mechanism SP2 is an increase of lateral strain per unit of applied voltage. We call this a "virtual" focusing due to the bending of the ridges and to contrast this with a true focusing or alignment towards a focal point achievable by actually tilting the ridges as will be explained in more detail below at Figures 11-13.

According to a further option there is a second stiffening plate SP1 fixed rigidly to the non-ruled face of the grating structure GI distal from the ruled surface, that is, distal from the ridges. In other words, in this situation the grating structure GI is clamped in a sandwich-like manner between the two relatively thin rigid stiffening plates SP1, SP2. The second plate SP1, in isolation and in combination with plate SP2, acts as a booster to further increase lateral strain per voltage efficiency by allowing substantially only the tip portions 206 to deform laterally whilst remaining portions of the grating, in particular body 202, are being held flat.

In one example, the stiffening plates SP1, SP2 are formed from a suitable material having a higher stiffness than the grating structure and/or the electrostrictive layer EL, such as CFK (carbon reinforced epoxy) or other. The two stiffening plates SP1, SP2 may be formed from the same material or may be formed from different materials. They may have the same stiffness or they may have different stiffness (eg, because of different thicknesses), each corresponding to different stiffness's requirements of the electrostrictive layer and the grating structure, respectively. Preferably, the plates SP1, SP2, when viewed in Z direction, correspond in shape and/or size with that of the grating G1. Preferably the stiffening plates SP1, SP2 are coextensive with the grating Gi and the layer EL. The stiffening elements SP1, SP2 not necessarily cover the whole of the respective faces of the grating or layer EL. For instance, the stiffening plates SP1, SP2 may not necessarily form closed surfaces but may have "through-holes" or perforations. For instance, one or (if any) both of the plates SP1, SP2 may be arranged as a respective grid or mesh structures

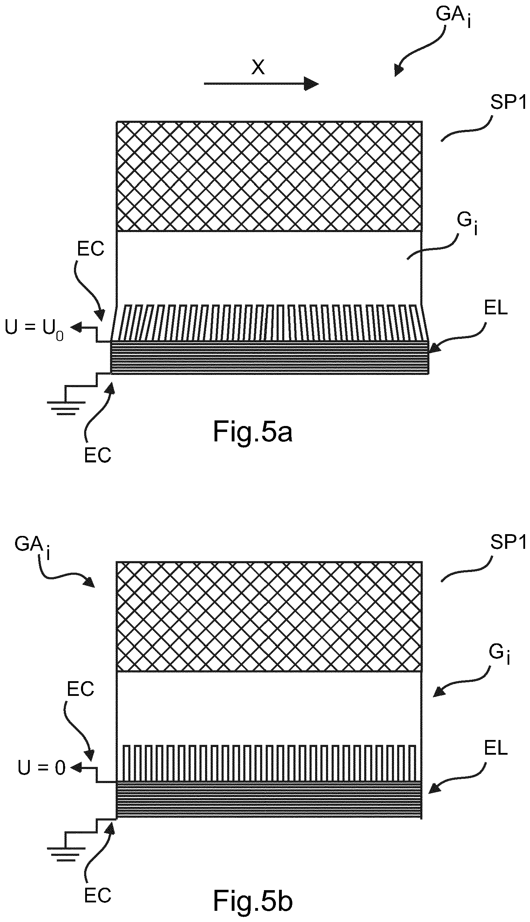

Figures 5a), b) show two cross sectional views of a grating assembly GAi As in Figures 2, 3 above, views a), b) represent the two states, deformed and un-deformed, respectively. This is in general similar to the Figures 2, 3 but the second stiffening plate SP2 is omitted. In other words, there is only a single stiffening plate SP1 coupled to the gratings structure Gi as previously explained in the Figures 2, 3 This single stiffening-plate helps to restrict the deformation action (in particular the lateral strain, as induced by the expansion of the electrostrictive later EL) to the ridges of the grating structure. The remainder of the grating structure, in particular the base body 202, remains undeformed or at least substantially undeformed. As mentioned above, the substrate 202 of the grating is affixed, eg, glued, onto the flattening plate SP1 in order to ensure the flatness of the grating base. The electrostrictive layer EL is provided with compliant electrodes EC and is also glued onto the tips 206 of the grating. The electrostriction process now will cause the layer EL to expand laterally in horizontal direction with both - its upper and lower surface. The cross-section remains rectangular with no shear stresses showing up. Because in this situation only a single stiffening plate SP1 is used, the sensitivity *Q* (strain per square unit of electric field) of the electrostriction process is roughly halved (that is, the factor "2" in eq (1) drops out).

When taking as a numerical example $Q \sim 5 \times 10^{-16}$ m$^2$/V$^2$ for the magnitude of the electrostrictive coefficient Q and one applies a 100 $\mu$m thick layer of polyurethane based polyester to the grating Gi, applicant observed that one achieve in some imager IM (such as mammography imagers) the desired focal spot focusing by application of a voltage of only about $U_0 \sim$ 30 V. The bending of the tips 206 of the grating ridges towards the outer edges of the grating Gi in this case is around 1 $\mu$m. The 30 V applied to the 100 $\mu$m foil (E= 0,3 MV/m) are far less than the electric breakdown strengths of elastomer films ($\sim$ 50 to 200 MV/m).

For the electrostrictive layer EL, any suitable amorphous or vitreous solid can be used. In particular the electrostrictive layer EL has a non-crystalline structure. More specifically in one embodiment the electrostrictive layer EL is a silicone or polyurethane based polymer. Yet more specifically the electrostrictive layer EL is a dielectric elastomer. The amorphous or vitreous material character of the electrostrictive layer EL confers elasticity. In other words, the electrostrictive layer returns to its original shape if no voltage is applied. Put differently, in order to maintain the focusing state where the ridges are non-parallel and aligned with the focal spot of the imager, the voltage must remain switched on during the imaging. Switching off the voltage will result in the layer EL reverting to its non-excited state so that the focusing of the ridges is lost as the ridges are then again parallel. Suitable electrostrictive materials are described for instance by I. Diaconu et al in "Electrostriction of a Polyurethane Elastomer-Based Polyester", IEEE Sensors Journal, Vol 6, No 4, 2006, pp 876-880 or by R. E. Pelrine et al in "Electrostriction of polymer dielectrics with compliant electrodes as a means of actuation", Sensors and Actuators A 64 (1998) pp 77-85.

Repeated X-ray exposure of the electrostrictive layer EL may lead over time to some degree of degradation. However it has been found that one can to some extent "repair" the layer EL by occasional tempering and/or curing at suitable temperatures. The temperatures used for this repair treatment and the frequencies and/or duration of application will in general depend on characteristics of the electrostrictive layer EL at hand such as its thickness, the material used etc. This X-radiation repair treatment may be implemented by simple exposure from an external microwave or infrared source. Alternatively, this source may be integrated into the imager. Thermal heating by heating wires integrated into the assembly GAi is also envisaged. For instance, one or more loops of heating wire may be integrated into a frame of the grating assembly GAi to effect the repair treatment by curing or tempering. Preferably, the layer EL is coextensive with the ruled surface of the grating to which it is applied. In other words, the layer EL covers the whole of the ruled surface of the grating. However embodiments where the layer EL is smaller or larger in area than the ruled surface of the gratings are not excluded herein.

The pair of electrodes EC for application of the activation voltage to the electrostrictive layer EL can be arranged as discrete, compliant, components. For instance, in one embodiment, the electrodes are respective coatings from a suitable material such as graphic powder or from a suitable metal applied to both faces of the electrostrictive layer. In particular, the electrodes can be arranged as looped structures (closed loop structures) so as to promote creation of a homogeneous electric field across the electrostrictive layer.

Alternatively, a discrete arrangement of the electrodes as separate components can be avoided by using both, the stiffening plate SP2 and the grating structure, themselves as respective electrodes, sandwiching the electrostrictive layer as shown in the Figures 2,3. In Figure 5 where only a single stiffening plate SP1 is used, one electrode is applied as a coating to the distal side of the electrostrictive layer EL while the role of the second electrode is assumed by the grating structure. If the gratings GI and the stiffening plates are used as electrodes it must be ensured they have the required electric conductivity. For instance, these components can then be formed from silicon or metal based components. For electrostrictive layer EL thicknesses equal or in excess of about 10 times the grating Gi pitch, the electric field is sufficiently homogenous across the layer EL's thickness, so no significant loss of efficiency of the electrostrictive effect is expected. It should be clear from the above Figures 2-3 and 5, that instead of using plates SP2 or SP1, a system of electrodes EC with at least one electrode being non-compliant can be used instead to implement the deformation constraints as per Figs 4c, d.

In order to increase the mechanical coupling between the grating structure and the stiffening plate and the electrostrictive layer, respectively, a suitable adhesion layer can be interposed between the respective faces. In particular, at the interface between the ridge tips 208 and the respective surface of the electrostrictive layer, rather than gluing the tips directly onto the electrostrictive layer, the adhesion layer is interposed in between. This not only promotes better rigid coupling, but also prevents glue to seep into the trenches when the grating structure G$_i$ and the electrostrictive layer are urged towards each other when gluing them together.

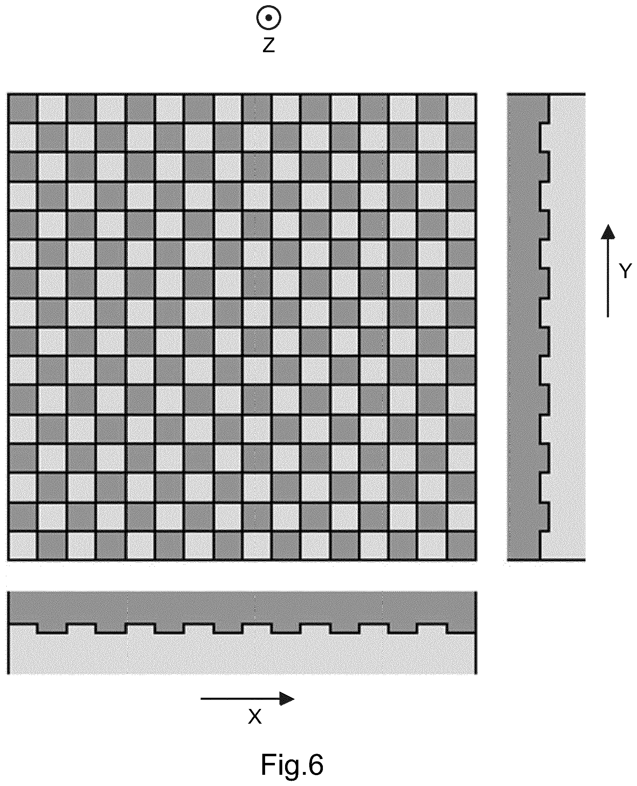

Figure 6 shows the solution claimed as the present invention of how to promote grip and mechanical coupling between the respective surface pairs, namely the opposing faces of the electrostrictive layer and the grating structure Gi and, optionally, the opposing faces of the stiffening plate SP1 and grating structure G$_i$, respectively. The face of the electrostrictive layer that is to be coupled to the terminal portions 208 of the ridges RD, is structured by roughening or otherwise by application of a pattern to form contact surfaces that interlock with each other during lateral expansion of the layer EL. More specifically, the respective face of the electrostrictive layer is structured by a pattern of saw tooth profile or rectangular indentations, each formed in shape and size to at least partly receive one or more of the terminal portions of the grating when the layer is urged into the contact with the grating Gi. The terminal tip portions 208 are brought into registry with respective ones of the indentations, thus effectively interlocking the grating and the layer during lateral expansion of the later, whilst the ridges RD are then being bent over and into alignment with the focal spot. The indentations or "patches" can be symmetric or asymmetric. For an exemplary embodiment, the receiving face of the electrostrictive layer is structured asymmetrically into rectangular or strip patches such as 10 $\mu$m to 100 $\mu$m in y direction along the ridges RD and about 0,1 $\mu$m to 0,3 $\mu$m along the x axis, perpendicularly across the ridge RD directions, assuming a ridge width of about 1 $\mu$m. The height or "depth" of the patches is around 0,1 $\mu$m to 1 $\mu$m. The patches may also be arranged as (fully) symmetric structures such as squares or other shapes.

A similar structuring for grip improvement may be applied to the distal face of the grating structure and the stiffening plate SP. An exemplary embodiment with rectangular structures, are shown in the two side profiles in X and Y direction to the right and bottom in Figure 6. The central portion of Figure 6 affords a plan view in Z direction and onto the surface of the electrostrictive layer or the non-ruled, distal, face of the grating structure. The heavily shaded squares represent embossed regions whereas the pale, light squares represent depressions. In use, the embossed regions of one face are in registry with corresponding depressions formed in the other face to interlock against lateral strain along the X axis, caused by the lateral expansion of the electrostrictive layer EL when the voltage is applied thereacross. Although the pattern in Fig 6 is two-dimensional, a 1-dimensional pattern may be sufficient to interlock against lateral strain along the x direction across the course of the ridges RG. In any of these embodiments, the application of pattern to the respective faces can be done for instance by stamping or die embossing or others.

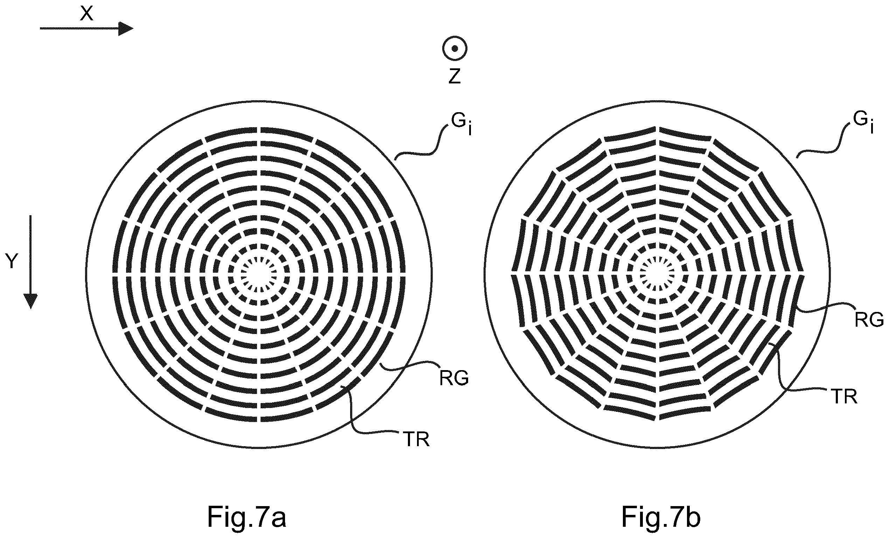

Although the grating ridges RD, and hence the trenches, are in one embodiment extending continuously and/or linearly across the surface of the grating structure GI, alternative embodiments of this are also envisaged. For instance, the trenches and gratings may be interrupted by transverse gaps or "cuts" so do not form continuous lines. This allows easier bending of the ridges by the lateral deformation of the electrostrictive layer EL. In yet another embodiment, and as shown in Figures 7a, b, ridge RG courses other than linear are also envisaged. The views afforded by Figures 7a and 7b are along the z axis thus affording a plan view. In Figure 7a for instance, the grating ridges RG do not run linearly but are arranged as a set of concentric circles, each circle shown in bold black rendering representing a respective ridge with respective circular trenches in between. Again, in order to reduce ridge stiffness to thus promoting easier bending or tilting, the respective circular ridges are interrupted in one embodiment by a series of gaps, transversely cutting across the ridges as mentioned above for the linear arrangement. The gaps may be arranged uniformly as shown in Figure 7a but may also be arranged at random in irregular patterns across each ridge RG. In the regular pattern as per Figure 7a, the ridge gaps are also arranged radially aligned. In Figure 7b the ridges are arranged in a polygonal fashion nested into each other. The individual "ridge polygons" RG are being formed by a series of liner ridge segments are arranged to form concentric polygons centered round the center point of the grating structure disc Gi. Again, the gaps formed between neighboring segments can be arranged regularly, more particularly regularly along each polygon and/or regularly radially across the plurality of concentrically arranged polygon segments.

It will be understood that the shape of the electrostrictive layer EL and/or the stiffening elements SP1, SP2, if any, are essentially co-extensive in shape and size with the grating structure. For instance in the previous Figures 1-6, the grating structure has, along the Z axis, an essentially rectangular or square footprint and so do the layer EL and the stiffening elements SP1, SP2 arranged as plates. In the embodiments where the grating is circular as in Figure 7, the electrostrictive layer and/or the stiffening elements conform to this by being arranged as stiffening disks rather than plates. However this conformance in shape is not necessarily present in all embodiments. For instance, embodiments are envisaged where circular gratings are combined with electrostrictive layers and/or stiffening plates having a different shape, for example rectangular. Or alternative, rectangular gratings are combined with a circular electrostrictive layer EL or stiffening disks SP1, SP2. Preferably there is requirement that the footprint (along the Z axis) of the grating structure is generally smaller than that of the electrostrictive layer or stiffening elements SP1, SP2.

On occasion, due to the stiffness of the grating ridges, the reaction forces of all ridges sum up. Especially at the vicinity of the center portion of the grating Gi (x=0). This may lead to an unwanted non-linear displacement profile of the ridges. In order to promote a linear displacement profile, a series of different electrode pairs may be used in correspondence to the nonlinear displacement profile of the ridges. Each pair of electrodes will then cause a different voltage. For instance, at a portion of the grating structure where there is the demand of higher total force for displacing the ridge tips (e.g. near x=0 of the X axis), a higher voltage is applied to cause a higher amount of lateral forces acting on those region of the ridges. In other words, rather than using a single electrode pair, a plurality of electrode pairs is used distributed over the grating $G_i$ and which are individually adjusted to provide a specific, location dependent voltage that corresponds to the local stiffness requirement. One way to achieve uniform displacement profile is to apply, in a calibration procedure, a uniform voltage to the grating structure and then to study the local displacement profiles. In different regions of the grating structure, different voltage requirements can then be recorded and a suitable series of electrodes with the respective voltages can then be designed. Alternatively, in order to achieve a linear displacement profile and rather than using a plurality of tailored electrode voltages as just described, an electrostrictive layer EL with varying, non-uniform thickness profile $d(x,y)$ can be used so as to compensate for these unwanted deviations from a linear tip displacement by $E(x,y) = U/d = U/d(x,y)$, with $E$ denoting the electrical field and $U$ the voltage and x,y locations on the grating relative to the axis X,Y.

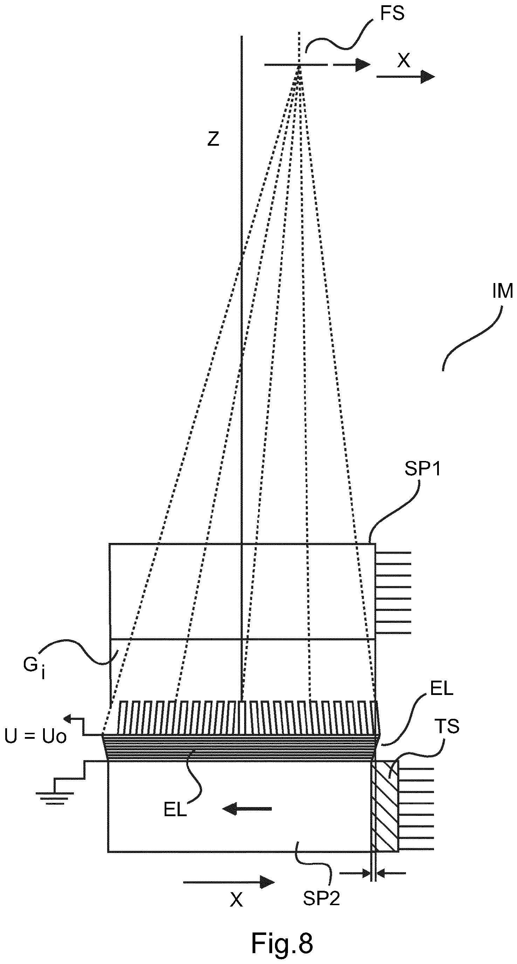

Referring now to Figure 8, this shows a further imaging apparatus including the grating assembly with the electrostrictive layer and further including a mechanical or, preferably electro-mechanical translation stage TS that acts on the lower stiffening plate SP2 so as to achieve a lateral displacement of the focal spot along the X axis. Alternatively, if the single stiffening plate embodiment is used, the translation stage TS may then act across the grating depth in X direction by applying the translation stage to the electrostrictive layer. In particular, the linear translation stage TS may be realized as a piezo-transducer. The upper plate SP1 is fixed against lateral displacement or, vice versa, the translation stage TS acts on the other (upper) plate SP1 and it is the lower plate SP2 that remains fixed. By a slight lateral shift of the lower plate SP2, the tip portions 206 of the gratings are altogether shifted in the same direction, in positive or negative direction along the X axis. The consequence is a lateral shift of the focal point in opposite direction. Thus by means of such a transducer TS, the position of the focal point of the grating system is adjustable to the match the lateral position of the focal spot of the X-ray tube XR. The lateral transducer stage may be of particular benefit for use with a multi-focal tube such as a dual or triple focus x-ray tube.

The interferometric imaging apparatus IM having one or more of the proposed grating assemblies GAi as described above includes in general a dedicated voltage source or at least a power connection to (both shown only in Fig 2 as "VS") drive the focusing of the grating structure within the respective grating assemblies. When combined with the translator stage TS as discussed and introduced above at Figure 6, the proposed imager offers to the user the possibility to adjust for grating focusing in two dimensions, that is in the X-Z plane. The position of the focal spot can be sought out or adjusted in Z direction by increasing or decreasing the voltage applied to the electrostrictive layer. The focal position can be independently shifted along the X direction that is to the left or right by applying a suitable voltage to the translation stage thereby eliciting a required shifting. The focusing of the gratings in either of the two directions that is in Z or X direction can be repeated at will of a calibration procedure to adjust for changes to the imager's geometry caused by external environmental factors. A high degree of tube energy efficiency can thus be ensured because radiation shadowing effects can be largely eliminated. In order to assist the user in focal spot focusing of the gratings, a suitable graphical user interface (GUI) may be provided, indicating the position of the focal spot of the X-ray source relative to a current position of the focal point as per the current grating(s) alignment. The user can operate suitable control means such as a button, joy stick or otherwise to change the respective voltages to be applied to the electrostrictive layer and/or the translation stage so as to achieve coincidence of the two points, that is, the focal spot of the x-ray source and the common focal point of the gratings. Control software for the GUI may run on a general purpose computer such as a work station (not shown) associated with the imager IM. The control software is capable of communicating via suitable interface circuitry with the one or two voltage sources for X- or Z-focusing of the gating(s). This arrangement then implements the following method to adjust the imager IM. In a first step S1, one or two voltages are received for shifting the focal point of one of the gratings GAi along the X and/or Z axis. In Step S2, the electrostrictive layer EL and or the translation stage are then activated to effect the respective shift of the common focal point along the X or Y axis. The steps can be repeated until coincidence with tube XR's focal spot is achieved. If more than one grating assemblies are being used in the imager IM, such as $GA_1$, $GA_2$ and/or $GA_0$, the respective voltage(s) for X- and/or Z-focusing can be applied separately or simultaneously to the two or more gratings assemblies. Each grating assembly $GA_i$ has their own common focal point, and preferably one adjusts each into coincidence with the focal spot FS of the tube XR.

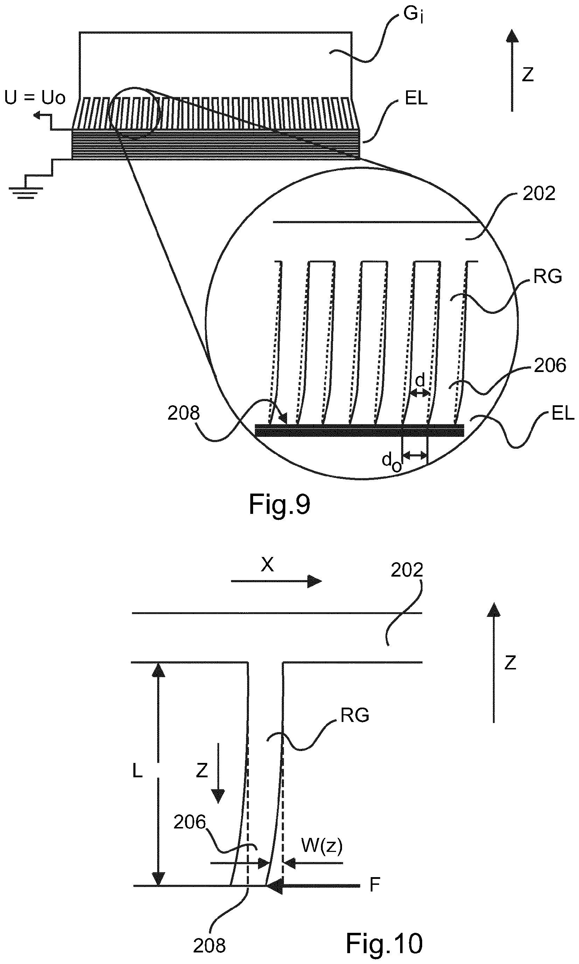

With reference to Figure 9, this discusses in more detail the effect of the lateral forces applied to the ridges RG by operation of the electrostrictive layer EL. As mentioned, due to the stiffness at the base portions 204 at which the ridges RD transition into the base body 202, of the effect of the electrostrictive layer deformation is rather a bending of the ridges than a tilting. However, if the flexibility of the grating structure material is sufficiently large, the desired increase in photon flux and visibility efficiency can be still achieved because radiation shadowing is reduced. If however the ridges RG are too stiff, in particularly as the base portions 204, higher reaction forces in response to the forces exerted due to the electrostrictive layer deformation will lead to non-linear of strain profiles of the grating-to-transducer foil EL boundary and thus to a degradation of the focusing capability. What is more, in addition to an unfavorable bending profile, the grating ridges RG will significantly deviate from a straight line. That is the effective gap width of the gratings will be decreased and thus the X-ray optical performance of the grating is further decreased as shown in the close-up of Figure 9. The close up as per Figure 10 shows an enlarged view of a single ridge RG having height L (= trench depth D). The bending profile $w(z)$ can be computed from the displacement forces as a function along the Z axis, where the z-coordinate measures the distance along the length of the ridge from its base portion 204 where it attaches to the base substrate 202 of the grating. The bending properties of a ridge RG rigidly coupled to base body 202 as in Figure 10 are governed by $w(L) = F*L^3 / (3Y*I_M)$ for the displacement versus force relation and $w(z) = 1/2 * w(L) /L^3 * (z^2 (z-3L))$ for the bending profile, with Y being the Young modulus, $I_M$ the geometrical moment of inertia, and $F$ the applied force. One can gather from these relations $w(z)$, $w(L)$ that for a high elasticity $1/Y$ only a small force $F$ will be necessary for achieving a preset tip displacement w(L) of the ridge RG. For the bending profile the situation is quite different. The bending profile is independent from the mechanical properties of the material and independent from its geometrical moment of inertia $I_M$ and thus the magnitude and shape of the cross-section of the bar. Modifications in Y and $I_M$ therefore will only affect the force issues.

According to the considerations in Figure 10, in order to promote easier bending and better performing the tilting of the respective ridges, it is proposed herein to form the grating structure from a material of sufficiently high elasticity, that is, from a material with sufficiently small Young modulus, with elasticity being measured by the quantity 1/Y (Y=elastic constant or Young modulus of the grating material). In one embodiment it is in particular the ridge structures RG that have a higher elasticity than the base substrate 202. Yet more specifically, the higher elasticity is ideally concentrated at the base portion 204 where the ridge attaches to the base body 202.

According to one embodiment, the localized, higher elasticity at the base portion 204 can be achieved as shown in Figure 11b where, as compared to the previous Figure 11a, the base portion 204 is tapered, thus "weakened" to achieve higher flexibility. In this manner, a joint region JT is formed. The tapering can be achieved by forming a stepped profile by removal of some material at the base portion or the transitioning in the tapered region is continuous. In either case, the joint region JT thus formed will promote an easier bending which is more akin a tilting reaction experienced via the lateral force along the X axis exerted on the ridge RG by expansion of the electrostrictive layer coupled to the grating at the terminal trip portions 208. The geometrical moment of inertia of the tapered section of the ridge RG is reduced. Thus the force necessary for displacing the tip of the grating ridge RG is reduced and most of the bending contributions of the grating bar are now taken up by the thinned joint JT regions.

According to another embodiment, the essentially monolithic structure of the grating body is abandoned. In other words, rather than having the base portion 202 seamlessly transition into the ridges RG as per Figure 11a or b, it is proposed in one embodiment to form an "articulated" grating structure which is no longer monolithic. In these articulated grating structure, the ridges RG form discrete parts, separate from the base body 202. The ridges are connected or coupled via joint structures JT to the base body 202, the joints JT being themselves discrete parts, formed from different materials than the ridges and the base body 202. As shown in Figure 11c, the flexible joints JT are provided as filler material of sufficiently high flexibility such as glue, at least partly received in furrows FR formed in the base body 202. The individual ridges RG are then coupled through the respective joints JT to the base body 202 to thus form, together, the articulated grating structure.

Figures 12a-c show further embodiments of the articulated grating structure. For instance, in Figure 12a, the furrows are formed as having a saw tooth profile. In Figure 12b the furrows are formed as troughs having a trapezoidal cross section. As per Figure 12c, the furrows are formed as the trough regions of a sinusoidal pattern applied to the respective surface of the base portion 202.

In either case, the furrows FR are suitable to receive at least in part or fully the filler material and/or at least a part of the base portion 206 of the respective ridges. In one embodiment the furrows run in Y direction (that is, into the plane of the drawings) and the full length of the grating base body 202 but embodiments are also envisaged where the furrows are interrupted by gaps to receive respective segments of the ridges thus implementing an application of the interrupted profile arrangements as discussed earlier with respect to Figure 7. The furrow patterns can be applied to the base substrate by rolling or etching or otherwise.

The proposed articulated grating designs allow achieving reduced (or even minimal) reaction forces and reduced (if not minimal or negligible) bending of the grating ridges RG themselves during tip 208 displacement. Also, it will be understood, that, due to the articulated ridges, next to perfect or true alignment or true focusing of the grating assembly towards a geometrical focal point can be achieved. This is possible because now the ridges are tilted and thus allow the geometrical definition of the focal point as the intersection of imaginary lines that run parallel along the heights d of the respective ridges RD. This "true" or full alignment thanks to the articulations can be contrasted with the previously described example (not forming part of the invention) in Fig 9, where there are no articulations and where the operation of the electrostrictive layer EL results in a bending of the ridges rather than a tilting. In this situation we only have partial alignment and the focal point "degenerates" into a "virtual" focal region rather than a point. It still is to be noted that even in the case of partial alignment due to bending, an increase in visibility can still be achieved albeit not at as pronounced as with the tilting of the ridges. In other words, "alignment" or "focusing" as used herein are to be construed to cover both, partial and full alignment/focusing, respectively.

Although in the above examples and embodiments, the electrostrictive layer EL acts only to deform a part of the gratings Gi, namely the ridges or the tips thereof, this is not limiting. Embodiments are envisaged where the whole of the gratings bend over to bring about the focusing of the ridges toward as a common focal point/region although the forces required to achieve this will be larger than when acting to merely deform the ridges and not the grating as a whole.

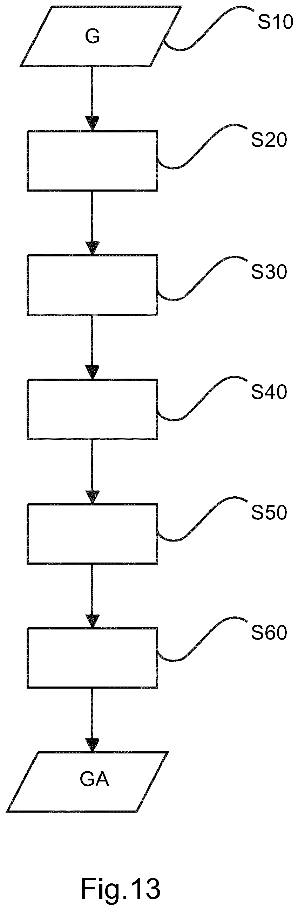

Reference is now made to Figure 13 where a method is explained for manufacturing an articulated grating structure.

At step S10, a conventionally manufactured diffraction grating G is provided, having grating ridges rigidly coupled to the grating's base substrate 202, with trenches TR incorporated into the substrate 202 between any two neighboring rides RG. The grating G may be silicon based but other materials are not excluded herein.

At step S20, the trenches are at least partly filled with a geometric stabilizer (e.g. paraffin/wax type of material or micro-bubble type of foam or others) for geometrically stabilizing the ridges RG. The foam is preferably formed from low atomic number molecules ($Z \leq 9$).

At step S30, the electro-mechanic transducer foil EL is applied onto the grating tips 206 of the ridges RG. This can be done by gluing or other affixing procedure.

At step S40, the grating substrate is then removed, e.g., by etching or otherwise.

At step S50, a grating support is applied to then now exposed former base portions of the ridges 204. The grating support thus replaces the former base body 202 removed in step S40. The grating support can be made from the same material (e.g. silicon) as the base body 202 but this may not be so necessarily. Preferably the grating body has a grooved or furrowed surface which can be achieved by stamping, embossing, etc. The grating support is then urged on the exposed base portions of the ridge and into registry therewith after a filler material such as glue has been introduced into the furrows.

At step S60, the stabilizer previously applied at step S20 is then removed by evaporation for instance to arrive at the articulate grating assembly GA. Appropriate venting channels need be provided in advance to the grating system elsewhere. The necessity of removing the foam depends on the desired stiffness. One may skip step S60 entirely or remove only part of the filler material or venture to remove all of the filler material to achieve ultimate flexibility to best mimicking good approximation true tilting behavior when the layer exerts the lateral force on the tips during application of the activation voltage.

The grating assemblies $GA_i$ having the electrostrictive layer as proposed herein are envisaged to replace the source grating G0 and/or one or both of the interferometer gratings G1 and G2 in a conventional DPCI apparatus. For instance, in one embodiment, each of the source grating G0, phase grating G1 and analyzer gratings G2 are incorporated in their respective grating assemblies GA1, GA2, each having their electrostrictive layer to align for the imager's focal spot FS. However, in another embodiment it is only one of the two or three gratings that is provided as a grating assembly, the other grating(s) being a conventional gratings without the electrostrictive layer. Preferably, it is the analyzer grating G2 hat is provided as a respective grating assembly GA2 with the electrostrictive layer EL as proposed herein to ensure maximum flux and visibility efficiency. Another preference is to have the phase grating G1 arranged in a gratings assembly GA1 as described herein.

It will be understood that the above described grating assembly GAi articulated ridges (for instance as per Figs 11-13) are particularly useful for absorber gratings G0 and G1 where, as described above, absorber filling material (eg gold) is introduced into the trenches. The reason for this is as follows. The presence of the absorber filling material would normally make a bending or tilting of the ridges difficult to achieve. To address this, we take advantage here of a processing technique for such gratings where air gaps are formed in the filling material between the ridges. In other words, the filler material does not occupy in x-direction the whole width of the trenches between any two consecutive ridges. This can be achieved by removal of every other ridge for instance. The sequence of materials in X direction is therefore (using gold as an example for the absorber filler material and silicon as the wafer material for the ridges) "Au-Si-Au-air-Au-Si-Au-air", etc. In other words, each remaining ridge has now a layer of gold to its left and right to form a thickened "Au-Si-Au" ridge and these "Au-Si-Au"-ridges are separated by respective air gaps. Because of these air gaps, a bending via the electrostrictive layer is now possible although more difficult as compared to when no absorber filling material is present. In this situation then, the articulated ridges are of particular benefit as this promotes easier tilting because of the presence of the air gaps.

It has to be noted that embodiments of the invention are described with reference to different subject matters. In particular, some embodiments are described with reference to method type claims whereas other embodiments are described with reference to the device type claims. However, a person skilled in the art will gather from the above and the following description that, unless otherwise notified, in addition to any combination of features belonging to one type of subject matter also any combination between features relating to different subject matters is considered to be disclosed with this application.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art in practicing a claimed invention, from a study of the drawings, the disclosure, and the dependent claims.

In the claims, the word "comprising" does not exclude other elements or steps, and the indefinite article "a" or "an" does not exclude a plurality. A single processor or other unit may fulfill the functions of several items re-cited in the claims. The mere fact that certain measures are re-cited in mutually different dependent claims does not indicate that a combination of these measures cannot be used to advantage. Any reference signs in the claims should not be construed as limiting the scope.

**Claims**

1. A grating assembly (GAi), comprising:

   - a grating structure (Gi) configured to modify X-ray radiation; and
   - a layer (EL) of electrostrictive material coupled to a first face of said grating structure,

   wherein at least a part of the grating structure (Gi) is deformable upon application of a voltage across the layer (EL) of electrostrictive material, **characterised in that** the first face of the grating structure and an opposing face of the electrostrictive layer are structured so as to interlock with each other.

2. A grating assembly as per claim 1, the grating structure (Gi) having ridges (RG) and the deformation causes said ridges (RG) to at least partly align towards a focus region or focus point located outside said grating assembly (GAi).

3. A grating assembly as per claim 2, said ridges (RG) having respective tip portions (208) that together form said first face of the grating structure (Gi).

4. A grating assembly, as per claim 2 or 3, wherein the grating structure (Gi) is arranged in an articulated manner with respect to at least one of the ridges.

5. A grating assembly as per any one of the previous claims, comprising a stiffening element (SP1) coupled to a second face of said grating structure (Gi) distal from said layer (EL) of electrostrictive material.

6. A grating assembly as per any one of the previous claims, comprising a or a further stiffening element (SP2) coupled to the layer (EL) of electrostrictive material so as to sandwich the layer (EL) of electrostrictive material between said further stiffening element (SP2) and said grating structure (Gi).

7. A grating assembly, as per any one of the previous claims 4-6, wherein the second face of the grating structure and an opposing face of the stiffening element (SP 1) are structured so as to interlock with each other.

8. An X-ray imaging apparatus (IX), comprising:

   - an X-ray source (XR) to emit the X-radiation from a focal spot (FS); and
   - a grating assembly (GAi) as per any of the previous claims.

9. An X-ray imaging apparatus (IX) as per claim 8, comprising a voltage source (VS) or a at least a power connector for applying a voltage to said grating assembly so as to align ridges of said grating assembly towards a focal region, wherein a position of said focal region varies with said voltage along an axis parallel to an optical axis of said X-ray imaging apparatus.

10. An X-ray imaging apparatus (IX) as per claim 9, comprising a translator stage (TS) configured to apply a lateral force to the grating assembly across an optical axis (OA) of the X-ray imaging apparatus thereby causing a lateral shift of said focal region or point along an axis perpendicular to the optical axis of the X-ray imaging apparatus.

11. An X-ray imaging apparatus (IX) as per claim 10, configured for varying said voltage and/or said lateral force such that the focal region is positionable to include said focal spot.

12. Method of manufacture of a grating assembly configured to modify X-ray radiation, the method comprising the steps of:

   - providing (S10) a grating structure comprising a base substrate with ridges projecting away from said bases substrate, said grating structure having respective tip portions and respective base portions distal from said tip portions, said ridges transitioning into said base substrate via said respective base portions; and
   - mounting (S20) a layer of electrostrictive material onto said tip portions.

13. Method of manufacture of a claim 12, comprising the step of, prior to the mounting, filling trenches, formed between said ridges, with a stabilizer

**Patentansprüche**

1. Gitterbaugruppe (GAi), umfassend:

   - eine Gitterstruktur (Gi), die konfiguriert ist, um Röntgenstrahlung zu modifizieren; und
   - eine Schicht (EL) aus elektrostriktivem Material gekoppelt mit einer ersten Fläche der genannten Gitterstruktur,

   wobei mindestens ein Teil der Gitterstruktur (Gi) bei Anlegen einer Spannung an die Schicht (EL) aus elektrostriktivem Material verformbar ist,
   **dadurch gekennzeichnet, dass** die erste Fläche der Gitterstruktur und eine gegenüberliegende Fläche der elektrostriktiven Schicht so strukturiert sind, dass sie ineinandergreifen.

2. Gitterbaugruppe nach Anspruch 1, wobei die Gitterstruktur (Gi) Grate (RG) hat und die Verformung bewirkt, dass sich die genannten Grate (RG) zumindest teilweise auf eine Fokusregion oder einen Fokuspunkt außerhalb der genannten Gitterbaugruppe (GAi) ausrichten.

3. Gitterbaugruppe nach Anspruch 2, wobei die genannten Grate (RG) jeweilige Spitzenabschnitte (208) haben, die zusammen die genannte erste Fläche der Gitterstruktur (Gi) bilden.

4. Gitterbaugruppe nach Anspruch 2 oder 3, wobei die Gitterstruktur (Gi) in einer gelenkigen Weise in Bezug auf mindestens einen der Grade angeordnet ist.

5. Gitterbaugruppe nach einem der vorhergehenden Ansprüche, umfassend ein Versteifungselement (SP1) gekoppelt mit einer zweiten Fläche der genannten Gitterstruktur (Gi) distal von der genannten Schicht (EL) aus elektrostriktivem Material.

6. Gitterbaugruppe nach einem der vorhergehenden Ansprüche, umfassend ein oder ein weiteres Versteifungselement (SP2) gekoppelt mit der Schicht (EL) aus elektrostriktivem Material, um so die Schicht (EL) aus elektrostriktivem Material zwischen dem genannten weiteren Versteifungselement (SP2) und der genannten Gitterstruktur (Gi) einzuschließen.

7. Gitterbaugruppe nach einem der Ansprüche 4 bis 6, wobei die zweite Fläche der Gitterstruktur und eine gegenüberliegende Fläche des Versteifungselementes (SP1) so strukturiert sind, dass sie ineinandergreifen.

8. Röntgenbildgebungsgerät (IX), umfassend:

   - eine Röntgenquelle (XR) zum Emittieren der Röntgenstrahlung von einem Brennfleck (FS); und
   - eine Gitterbaugruppe (GAi) nach einem der vorhergehenden Ansprüche.

9. Röntgenbildgebungsgerät (IX) nach Anspruch 8, umfassend eine Spannungsquelle (VS) oder mindestens einen Stromversorgungsanschluss zum Anlegen einer Spannung an die genannte Gitterbaugruppe, um so die Grate der genannten Gitterbaugruppe auf eine Fokusregion auszurichten, wobei eine Position der genannten Fokusregion mit der genannten Spannung entlang einer Achse parallel zu einer optischen Achse des genannten Röntgenbildgebungsgeräts variiert.

10. Röntgenbildgebungsgerät (IX) nach Anspruch 9, umfassend eine Translationsbühne (TS), die konfiguriert ist, um eine laterale Kraft auf die Gitterbaugruppe über eine optische Achse (OA) des Röntgenbildgebungsgeräts auszuüben und dadurch eine laterale Verschiebung der genannten Fokusregion oder des genannten Fokuspunkts entlang einer Achse senkrecht zu der optischen Achse des Röntgenbildgebungsgeräts zu bewirken.

11. Röntgenbildgebungsgerät (IX) nach Anspruch 10, das konfiguriert ist, um die genannte Spannung und/oder die genannte laterale Kraft derartig zu variieren, dass die Fokusregion so positioniert werden kann, dass sie den genannten Brennfleck einschließt.

12. Verfahren zur Herstellung einer Gitterbaugruppe, die konfiguriert ist, Röntgenstrahlung zu modifizieren, wobei das Verfahren die folgenden Schritte umfasst:

   - Bereitstellen (S10) einer Gitterstruktur umfassend ein Basissubstrat mit Graten, die aus dem genannten Basissubtrat herausragen, wobei die genannte Gitterstruktur jeweilige Spitzenabschnitt und jeweilige Basisabschnitte distal von den genannten Spitzenabschnitten hat, wobei die genannten Grate über die genannten jeweiligen Basisabschnitte in das genannte Basissubstrat übergehen; und

- Montieren (S20) einer Schicht aus elektrostriktivem Material auf den genannten Spitzenabschnitten.

**13.** Verfahren zur Herstellung nach Anspruch 12, umfassend, vor dem Montieren, das Füllen von zwischen den genannten Graten gebildeten Gräben mit einem Stabilisator.


**Revendications**

**1.** Ensemble de grilles (GAi), comprenant :

- une structure de grille (Gi) configurée pour modifier un rayonnement X ; et
- une couche (EL) de matériau électrostrictif couplée à une première face de ladite structure de grille,

dans lequel au moins une partie de la structure de grille (Gi) peut se déformer lors de l'application d'une tension à travers la couche (EL) de matériau électrostrictif,
**caractérisé en ce que**
la première face de la structure de grille et une face opposée de la couche électrostrictive sont structurées de manière à s'emboîter l'une avec l'autre.

**2.** Ensemble de grilles selon la revendication 1, la structure de grille (Gi) ayant des nervures (RG) et la déformation entraîne lesdites nervures (RG) à au moins partiellement s'aligner en direction d'une région de focalisation ou d'un point de focalisation situé à l'extérieur dudit ensemble de grilles (GAi).

**3.** Ensemble de grilles selon la revendication 2, lesdites nervures (RG) ayant des portions pointe respectives (208) qui forment ensemble ladite première face de la structure de grille (Gi).

**4.** Ensemble de grilles, selon la revendication 2 ou 3, dans lequel la structure de grille (Gi) est agencée de manière articulée par rapport à au moins l'une des nervures.

**5.** Ensemble de grilles selon l'une quelconque des revendications précédentes, comprenant un élément de raidissement (SP1) couplé à une seconde face de ladite structure de grille (Gi) distal par rapport à ladite couche (EL) de matériau électrostrictif.

**6.** Ensemble de grilles selon l'une quelconque des revendications précédentes, comprenant un ou un autre élément de raidissement (SP2) couplé à la couche (EL) de matériau électrostrictif de manière à prendre en sandwich la couche (EL) de matériau électrostrictif entre ledit autre élément de raidissement (SP2) et ladite structure de grille (Gi).

**7.** Ensemble de grilles, selon l'une quelconque des revendications précédentes 4 à 6, dans lequel la seconde face de la structure de grille et une face opposée de l'élément de raidissement (SP1) sont structurées de manière à s'emboîter l'une avec l'autre.

**8.** Appareil d'imagerie par rayons X (IX), comprenant :

- une source de rayons X (XR) pour émettre le rayonnement X à partir d'un foyer thermique (FS) ; et
- un ensemble de grilles (GAi) selon l'une quelconque des revendications précédentes.

**9.** Appareil d'imagerie par rayons X (IX) selon la revendication 8, comprenant une source de tension (VS) ou au moins un connecteur d'alimentation pour appliquer une tension audit ensemble de grilles de manière à aligner des nervures dudit ensemble de grilles en direction d'une région de focalisation, dans lequel une position de ladite région de focalisation varie en fonction de ladite tension le long d'un axe parallèle à un axe optique dudit appareil d'imagerie par rayons X.

**10.** Appareil d'imagerie par rayons X (IX) selon la revendication 9, comprenant un étage de translation (TS) configuré pour appliquer une force latérale à l'ensemble de grilles sur un axe optique (OA) de l'appareil d'imagerie par rayons X provoquant ainsi un décalage latéral de ladite région ou dudit point de focalisation le long de l'axe perpendiculaire à l'axe optique de l'appareil d'imagerie par rayons X.

**11.** Appareil d'imagerie par rayons X (IX) selon la revendication 10, configuré pour faire varier la tension et/ou ladite force latérale de sorte que la région de focalisation puisse être positionnée pour inclure ledit foyer thermique.

**12.** Procédé de fabrication d'un ensemble de grilles configuré pour modifier le rayonnement X, le procédé comprenant les étapes suivantes :

- la fourniture (S10) d'une structure de grille comprenant un substrat de base avec des nervures faisant saillie à l'écart dudit substrat de base, ladite structure de grille ayant des portions pointe respectives et des portions base respectives distales desdites portions pointe, lesdites nervures assurant la transition vers ledit substrat de base par l'intermédiaires desdites portions base respectives ; et
- le montage (S20) d'une couche de matériau électrostrictif sur lesdites portions pointe.

**13.** Procédé de fabrication selon la revendication 12, comprenant l'étape de, avant le montage, remplissage des tranchées, formées entre lesdites nervures, avec un stabilisant.

Fig. 1a

Fig. 1b

Fig.2

Fig.3

Fig.4

GA$_i$

X

SP1

G$_i$

EC

EL

U = U$_0$

## Fig.5a

GA$_i$

SP1

G$_i$

EC

EL

U = 0

EC

## Fig.5b

Fig.6

Fig.7a

Fig.7b

EP 3 192 080 B1

Fig.8

$G_i$

Z

$U = U_0$

EL

202

RG

206

d

208

EL

$d_0$

## Fig.9

X

202

Z

RG

L

Z

206

W(z)

F

208

## Fig.10

EP 3 192 080 B1

Fig.11a          Fig.11b          Fig.11c

Fig.12a          Fig.12b          Fig.12c

Fig.13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6985294 B1

- JP 2008048910 A

**Non-patent literature cited in the description**

- **FRASETTO FABIO.** Devlopment of active gratings for the spectral selection of ultrafast pulses. *Optomechatronic micro/nano devices and components II, Proceedings SPIE,* 2013, 87780c
- **F PFEIFFER et al.** Phase retrieval and differential phase-contrast imaging with low-brilliance X-ray sources. *Nature Physics,* 2006, vol. 2, 258-261

- **A MOMOSE et al.** High-speed X-ray phase imaging and X-ray phase tomography with Talbot interferometer and white synchrotron radiation. *OPTICS EXPRESS,* 20 July 2009, vol. 17 (15
- **I. DIACONU et al.** Electrostriction of a Polyurethane Elastomer-Based Polyester. *IEEE Sensors Journal,* 2006, vol. 6 (4), 876-880
- **R. E. PELRINE et al.** Electrostriction of polymer dielectrics with compliant electrodes as a means of actuation. *Sensors and Actuators,* 1998, vol. A 64, 77-85